# EUROPEAN PATENT APPLICATION

(11) **EP 4 459 860 A1**
(43) Date of publication of application: **06.11.2024**
(21) Application number: 22915479.4
(22) Date of filing: 20.10.2022
(51) Int. Cl.: H02M 9/00, H05H 1/46

(54) **HIGH-FREQUENCY POWER SUPPLY**

(30) Priority: 28.12.2021 JP 2021214353
(71) Applicant: Kyosan Electric Mfg. Co., Ltd., Tsurumi-ku, Yokohama-shi Kanagawa 230-0031 (JP)
(72) Inventor: TEI Unbou, Yokohama-shi, Kanagawa 230-0031 (JP)
(74) Representative: Hoffmann Eitle
(86) International application number: PCT/JP2022/039055
(87) International publication number: WO 2023/127244

(57) **Abstract**

A high-frequency power supply (10) uses one pulse conversion/variable gain amplification unit (23) to perform two processing steps which are converting an RF signal into pulses and controlling an output level, and uses one control signal (27) to perform the pulse conversion and the output level control by the pulse conversion/variable gain amplification unit (23), thereby obviating the need for a modulation unit, which is a factor in the generation of jitter, overshoot, and undershoot, and reducing the number of control lines (29) for sending the control signal (27) to one control line. Due to this configuration, the jitter, overshoot, and undershoot generated in an RF pulse signal can be prevented, and the RF-signal pulse conversion and output level control are performed simultaneously using one control line (29).

## Description

### [TECHNICAL FIELD]

The present invention relates to a high-frequency power supply that outputs an RF pulse signal.

### [BACKGROUND ART]

It is known that RF pulse signals output from a high-frequency power supply are used for semiconductor manufacturing equipment and the like. The RF pulse signal is an RF signal (high-frequency signal) that is output in pulse form, and ON/OFF pulses and multilevel pulses are known as aspects that an output level of the RF pulse signal changes.

The ON/OFF pulse is an RF pulse signal whose output level changes repeatedly between two levels, namely a low level of zero level and a high level of a predetermined level, the output level changing in a constant cycle or a duty ratio. The multilevel pulse is an RF pulse signal whose output level changes repeatedly between a low level and a high level, but the low level does not become zero level. The output level of the multilevel pulse may change repeatedly with a two-stage pulse in the high level or a multistage pulse with three or more levels.

As power amplifiers included in a high-frequency power supply, there are known linear amplifiers that use class-A, class-B, class-AB, and class-C transistors in an analog manner, and switching amplifiers that use class-E and class-F transistors for switching.

There is a known high-frequency power supply that includes a modulation unit for modulating an RF signal into a pulse modulation signal, and a level modulation unit for modulating an output level of the pulse modulation signal by means of a linear power amplifier to generate an RF pulse signal (see Patent Literature 1).

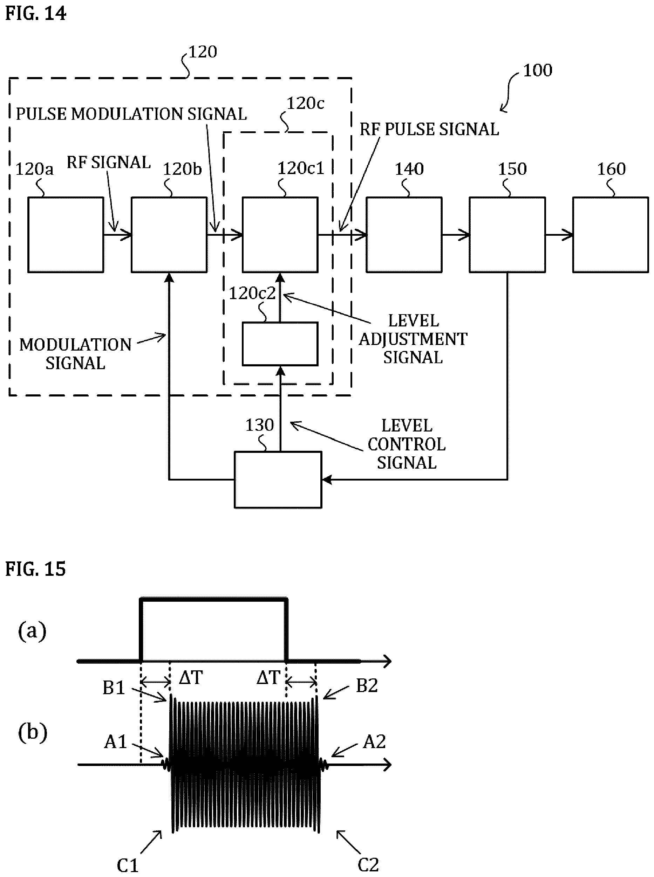

Figure 14 shows an example of a high-frequency power supply. A high-frequency power supply 100 generates an RF pulse signal by using an RF pulse signal generation unit 120 that includes an oscillation unit 120a, a modulation unit 120b and a level adjustment unit 120c. The modulation unit 120b modulates an RF signal (high-frequency signal) output from the oscillation unit 120a by using a pulsed modulation signal output from a control unit 130, and outputs an RF pulse signal that changes repeatedly between an ON state and an OFF state. The level adjustment unit 120c includes a D/A circuit 120c2 and a level modulation circuit 120c1. The D/A circuit 120c2 converts a level control signal output from the control unit 130 into a level adjustment signal in the form of an analog signal. The level modulation circuit 120c1 controls, by means of a linear power amplifier, an output level of the pulse modulation signal which is pulsed by the modulation unit 120b according to a level modulation signal to thereby output an RF pulse signal.

The RF pulse signal output from the level adjustment unit 120c is amplified by the power amplification unit 140 and is then supplied to a load 160. An output power detection unit 150 is provided between the power amplification unit 140 and the load 160 and is configured to divide output power into traveling-wave power and reflected-wave power to thereby detect each power. The control unit 130 feeds back the detected output power so as to output a modulation signal and a level control signal.

In this way, the high-frequency power supply 100 converts the RF signal into pulses by the modulation unit 120b and controls the output level by the level adjustment unit 120c to thereby output an RF pulse signal, in which the RF signal (high-frequency signal) is output in pulse form.

### [CITATION LIST]

### [PATENT LITERATURE]

[Patent Literature 1] International Publication No. WO2015/056509

### [SUMMARY OF THE INVENTION]

### [PROBLEMS TO BE SOLVED BY THE INVENTION]

In a conventional linear amplifier, when a DC bias circuit of a first-stage amplifier is switched at high speed, parasitic capacitances in a base and a gate of a semiconductor element cause a transient phenomenon at the timing of the rise or fall of an RF signal (high-frequency signal). It causes a problem that jitter and overshoot/undershoot occur in an RF pulse signal, leading to a waveform disturbance.

In a high-frequency power supply which outputs an RF pulse signal by means of a modulation unit and a level adjustment unit, it is necessary to provide two control lines, i.e., a control line for transmitting a modulation signal for pulse conversion from a control unit to the modulation unit and another control line for transmitting a level control signal for output level control from the control unit to the level adjustment unit.

Since the pulse conversion and the output level control are performed separately, it is necessary to provide a circuit configuration of the modulation unit in addition to that of the level adjustment unit, and it is also necessary to provide a plurality of control lines for transmitting the control signal to the modulation unit and the level adjustment unit. Thus, there is a problem of the increase in components for structuring the modulation unit and the control lines, as well as a problem that a time lag may occur between the control of the pulse conversion and the output level control.

Furthermore, when spurious (unnecessary emission) occurs in the modulation unit, a problem arises that the jitter and the overshoot/undershoot occur in the RF pulse signal thus pulsed, as with the case of the linear amplifier. FIG. 15 shows a waveform diagram that illustrates jitter and overshoot/undershoot in an RF pulse signal. FIG. 15(a) shows a modulation signal for the pulse conversion, and FIG. 15(b) shows an RF pulse signal on which the pulse conversion and the output level control are performed.

The RF pulse signal rises after a delay time ΔT when the modulation signal changes from an OFF state into an ON state, and the RF pulse signal falls after the delay time ΔT when the modulation signal changes from the ON state into the OFF state. When the RF pulse signal rises, jitter (A1) occurs and an overshoot (B1) and an undershoot (C1) also occur, and when the RF pulse signal falls, an overshoot (B2) and an undershoot (C2) occur and jitter (A2) also occurs. In here, the overshoot is a voltage that is excessively protruded on the positive side in the RF pulse signal and the undershoot is a voltage that is excessively protruded on the negative side in the signal.

Thus, the high-frequency power supply that includes the linear power amplifier, which outputs the RF pulse signal, has the following problems:
a) the jitter and the overshoot/undershoot occur in the RF pulse signal in the pulse conversion of the RF signal;
b) the number of the control lines increases;
c) the circuit configuration of the modulation unit increases; and
d) the spurious (unnecessary emission) occurs that causes the jitter and the overshoot/undershoot in the modulation unit.

It is an object of the present invention to solve the above-described conventional problems and prevent the occurrence of the jitter and the overshoot/undershoot in the RF pulse signal. It is another object of the present invention to simultaneously perform the pulse conversion and the output level control on the RF signal by one control line.

### [MEANS FOR SOLVING THE PROBLEM]

A high-frequency power supply of the present invention performs two processes, pulse conversion and output level control, on an RF signal by a single pulse conversion/variable gain amplification unit and performs the pulse conversion and output level control by the pulse conversion/variable gain amplification unit with a single control signal, so that no modulation unit which causes jitter and overshoot/undershoot is required, and thus the number of control lines for transmitting control signals can be reduced to one. Consequently, the occurrence of jitter and overshoot/undershoot in an RF pulse signal can be prevented, and the pulse conversion and the output level control on the RF signal can be performed simultaneously by one control line.

The high-frequency power supply of the present invention includes an RF pulse signal generation unit that converts an RF signal into pulses to generate an RF pulse signal, and a control unit that outputs setting data for controlling the RF pulse signal generation unit.

### <Setting Data>

The setting data used for generating the RF pulse signal includes:
(a) frequency setting data for setting a frequency of the RF signal; and
(b) control setting data for setting a cycle and a duty ratio of the RF pulse signal and an output level of the RF pulse signal, so as to define a pulse waveform of the RF pulse signal.

### <Configuration of RF Pulse Signal Generation Unit>

The RF pulse signal generation unit includes an RF signal generation unit as Configuration (A) for generating RF signals, a pulse conversion/level control signal generation unit and a pulse conversion/variable gain amplification unit as Configuration (B) for generating RF pulse signals from the RF signals, and a single control line as Configuration (C) for transmitting a control signal.

### (A) Configuration for generating RF signal

The RF signal generation unit is configured to generate an RF signal at a frequency set in the frequency setting data.

### (B) Configuration for generating RF pulse signal

(B1) The pulse conversion/level control signal generation unit is configured to generate a control signal for performing pulse conversion control according to a cycle and a duty ratio set in the control setting data and level control for controlling an output level set in the control setting data.

(B2) The pulse conversion/variable gain amplification unit is configured to perform the pulse conversion control according to the cycle and the duty ratio set in the control setting data based on the control signal to convert the RF signal into pulses, perform the variable control on an amplification gain of the RF signal based on the control signal, and perform the level control by adjusting the level of the RF signal to the set output level to generate an RF pulse signal from the RF signal.

### (C) Control Line

The control line is provided to connect the pulse conversion/control signal generation unit and the pulse conversion/variable gain amplification unit, and thereby a control signal is transmitted by a single control line. The control signal includes two control mode in one signal, namely the pulse conversion control and the level control, and is transmitted by the single control line so that the pulse conversion control and the level control can be performed simultaneously.

### <Control Signal>

For the generation of the control signal in the pulse conversion/level control signal generation unit of the high-frequency power supply of the invention, the control signal is made to have a sloping waveform on its rising and falling edges. It can provide a rise time and a fall time during the rise and the fall of the control signal in the generation of the RF pulse signal in the pulse conversion/variable gain amplification unit, thereby preventing the occurrence of the jitter and the overshoot/undershoot.

The high-frequency power supply of the invention has multiple configurations according to a form of the control signal and a form of the pulse conversion/variable gain amplifier unit. The form of the control signal includes a form of voltage signal or a form of control code. The form of the pulse conversion/variable gain amplifier unit includes a form of varying an amount of attenuation and a form of varying resistance and conductance. The multiple configuration examples can be achieved by the above-described forms.

### (First Configuration Example)

A first configuration example uses a voltage signal as a form of the control signal and has a variable attenuator amplifier as a form of the pulse conversion/variable gain amplification unit. In the first configuration example, the pulse conversion/variable gain amplification unit is formed by the variable attenuator amplifier that varies an amount of attenuation by using a control signal of the voltage signal. The variable attenuator amplifier includes a variable attenuator, and varies the amount of attenuation of this variable attenuator by using the control signal of the voltage signal to variably control an amplification gain, so as to control the level of the RF pulse signal.

The variable attenuator includes a semiconductor element, and varies the amount of attenuation of the RF signal in response to the change in a resistance component of the semiconductor element caused by the voltage signal, thereby variably controlling the amplification gain to control the level of the RF pulse signal. As a semiconductor element included in the variable attenuator, a field-effect transistor (FET) or a positive-intrinsic-negative (PIN) diode can be used. Furthermore, the variable attenuator can be configured with a network, such as a T-type circuit or π-type circuit, using the semiconductor element and resistive elements.

Since the voltage signal of the control signal sets a cycle and a duty ratio of an RF pulse signal by the time variation of the voltage while setting the output level of the RF pulse signal by an amplitude of the voltage, the pulse conversion control and the output level control can be performed at a time and the control signal can be transmitted by a single control line.

### (Second Configuration Example)

A second configuration example uses a control code as the control signal and the pulse conversion/variable gain amplification unit is formed by the variable attenuation amplifier. In the second configuration example, the pulse conversion/variable gain amplification unit is a variable attenuator amplifier that varies the amount of attenuation of the RF signal by using the control signal, and includes a plurality of resistors having different resistance values. The variable attenuator amplifier switches the resistors by using the control code to variably control the amplification gain, thereby controlling the level of the RF pulse signal.

Since the control code of the control signal sets the cycle and the duty ratio of the RF pulse signal as well as the output level of the RF pulse signal by using the code signal, the pulse conversion control and the output level control can be performed simultaneously and the control signal can be transmitted by the single control line.

### (Third Configuration Example)

A third configuration example uses a voltage signal as the control signal, and the pulse conversion/variable gain amplification unit is formed by a conductance amplifier. In the third configuration example, the pulse conversion/variable gain amplification unit is the conductance amplifier that includes a semiconductor element which varies mutual conductance by using the control signal, and the control signal is the voltage signal. The conductance amplifier variably controls the amplification gain due to the change in the mutual conductance of the semiconductor element caused by the voltage signal, thereby controlling the level of the RF pulse signal.

Since the voltage signal of the control signal sets the cycle and the duty ratio of the RF pulse signal by the time variation of the voltage while setting the output level of the RF pulse signal by the amplitude of the voltage, the pulse conversion control and the output level control can be performed simultaneously and the control signal can be transmitted by the single control line.

### (Fourth Configuration Example)

A fourth configuration example uses a control code as the control signal, and the pulse conversion/variable gain amplification unit is formed by the conductance amplifier that varies the mutual conductance by using the control signal. The conductance amplifier variably controls the amplification gain in response to the change in the mutual conductance caused by the control code, thereby controlling the level of the RF pulse signal.

The mutual conductance by the control code can be changed by changing capacitances or switching the conductance amplifiers.

In a form of the fourth configuration example, the conductance amplifier includes a plurality of capacitors having different capacitance values. The pulse conversion/variable gain amplification unit varies the mutual conductance by switching the capacitors by using the control code to variably control the amplification gain, thereby controlling the level of the RF pulse signal.

In another form of the fourth configuration example, the pulse conversion/variable gain amplification unit includes a plurality of conductance amplifiers having different mutual conductance values, and varies the mutual conductance by switching the conductance amplifiers by using the control code to variably control the amplification gain, thereby controlling the level of the RF pulse signal.

Since the control code of the control signal sets the cycle and the duty ratio of the RF pulse signal as well as the output level of the RF pulse signal by the code signal, the pulse conversion control and the output level control can be performed simultaneously and the control signal can be transmitted by the single control line.

### [EFFECT OF THE INVENTION]

As described above, according to the present invention, it is possible to prevent the occurrence of the jitter and overshoot/undershoot in the RF pulse signal. Furthermore, the pulse conversion and the output level control on the RF signal can be performed simultaneously by the single control line.

### [BRIEF DESCRIPTION OF THE DRAWINGS]

Figure 1 illustrates a schematic configuration of a high-frequency power supply according to the present invention;
Figure 2 shows an example of an RF pulse signal;
Figure 3 shows an example schematically showing a control signal and the RF pulse signal;
Figure 4 shows an example of the control signal;
Figure 5 shows a first configuration example of the high-frequency power supply according to the present invention;
Figure 6 shows a configuration example of a variable attenuator amplifier;
Figure 7 shows a second configuration example of the high-frequency power supply according to the present invention;
Figure 8 shows a third configuration example of the high-frequency power supply according to the present invention;
Figure 9 shows a fourth configuration example of the high-frequency power supply according to the present invention;
Figure 10 shows configuration examples of the variable attenuator amplifier and a conductance amplifier;
Figure 11 shows examples of a control signal and an ON/OFF pulse signal of the high-frequency power supply according to the present invention;
Figure 12 shows an enlarged view of the example of the ON/OFF pulse signal of the high-frequency power supply according to the present invention;
Figure 13 shows examples of the control signal and a multi-pulse signal of the high-frequency power supply according to the present invention;
Figure 14 shows an example of a high-frequency power supply which includes a linear power amplifier; and
Figure 15 shows a waveform chart which illustrates jitter and overshoot/undershoot in the RF pulse signal.

### [BEST MODE FOR CARRYING OUT THE INVENTION]

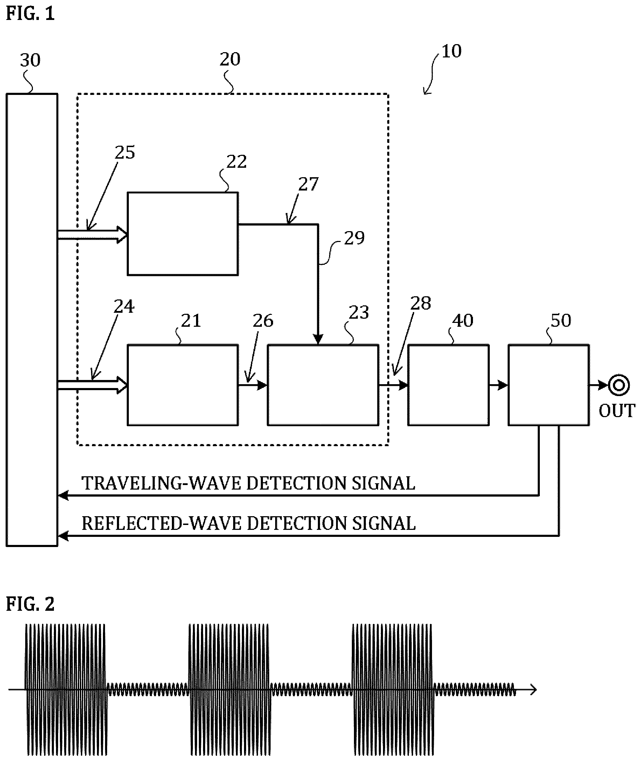

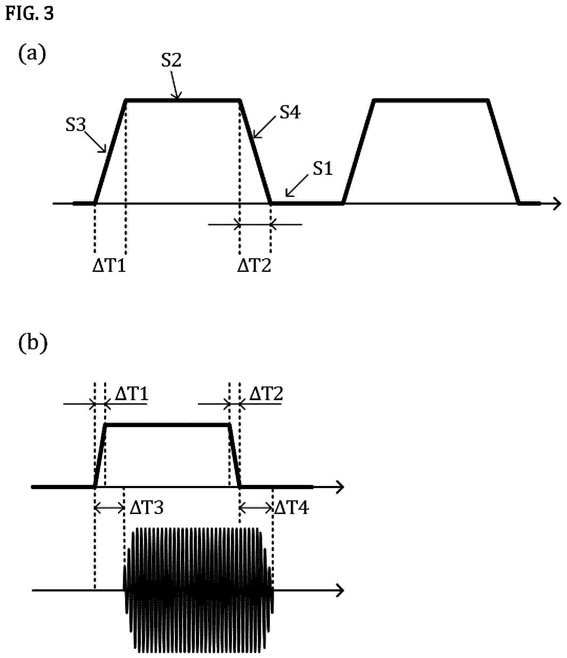

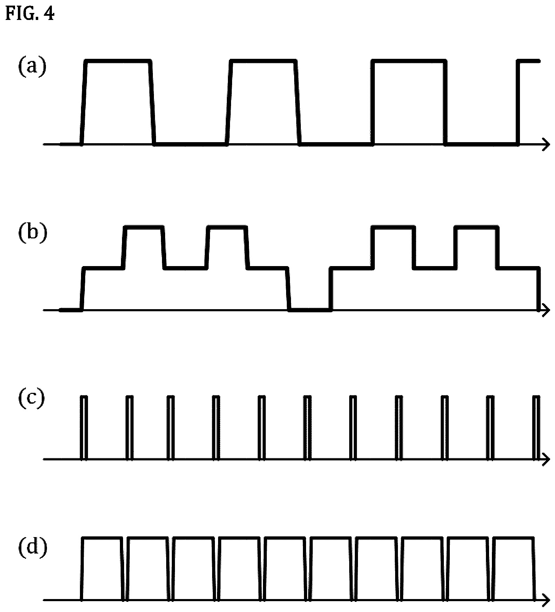

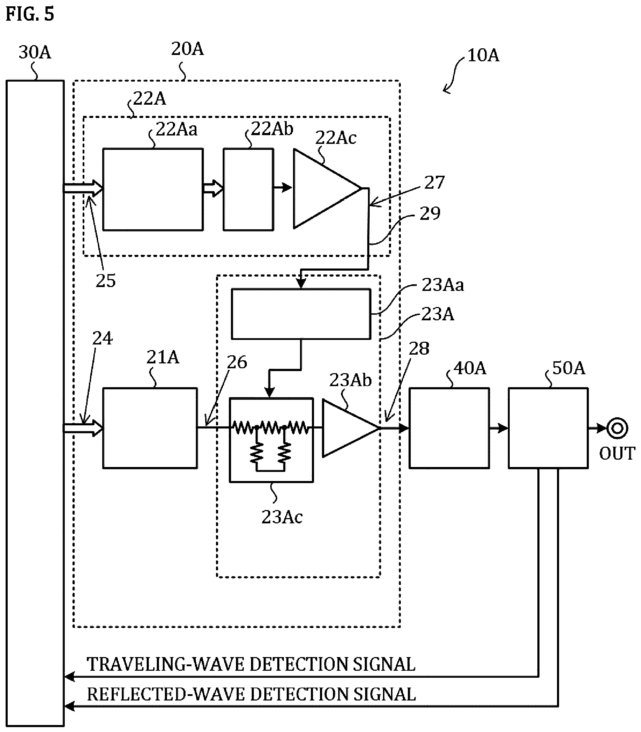

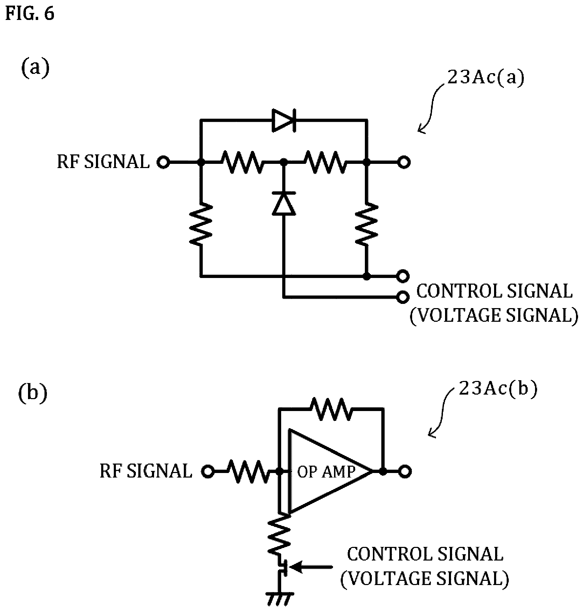

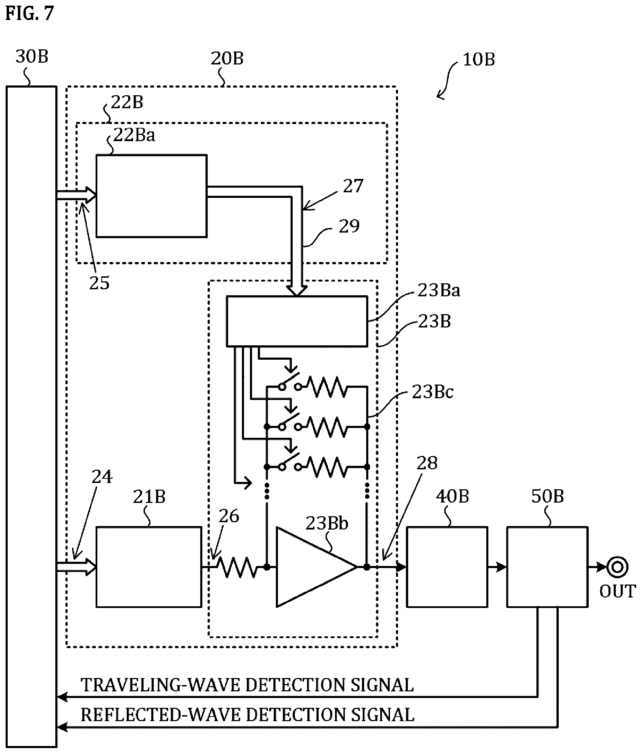

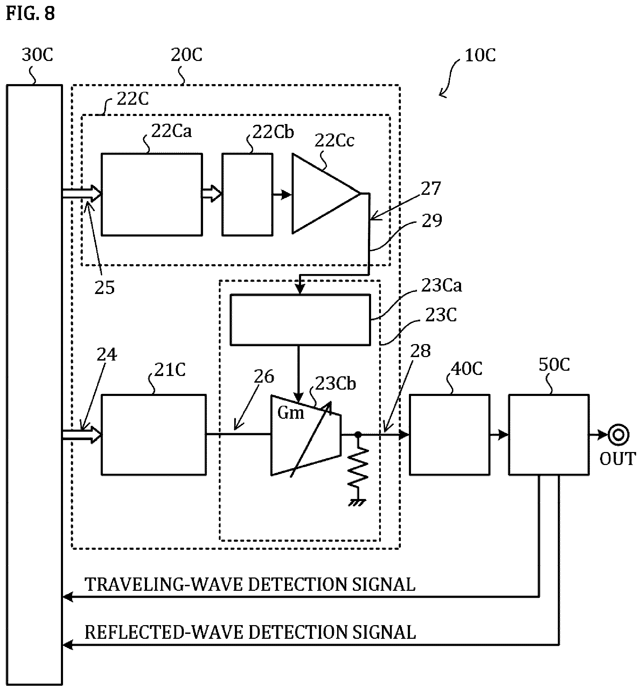

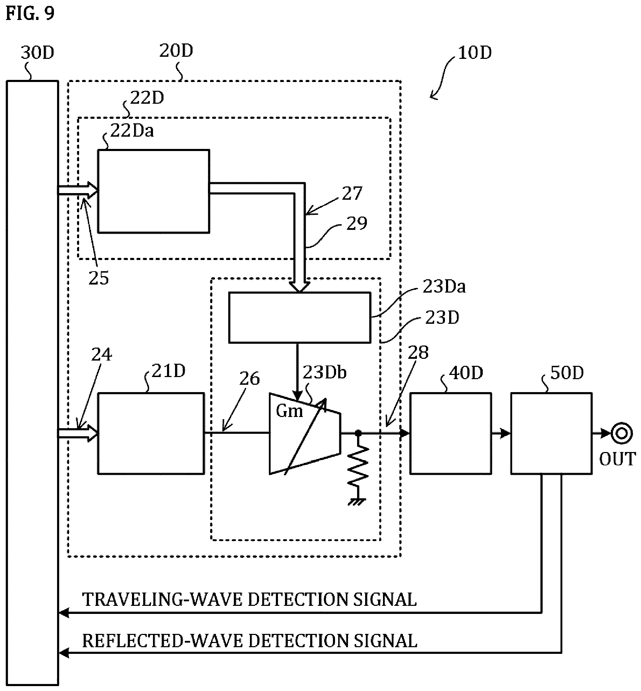

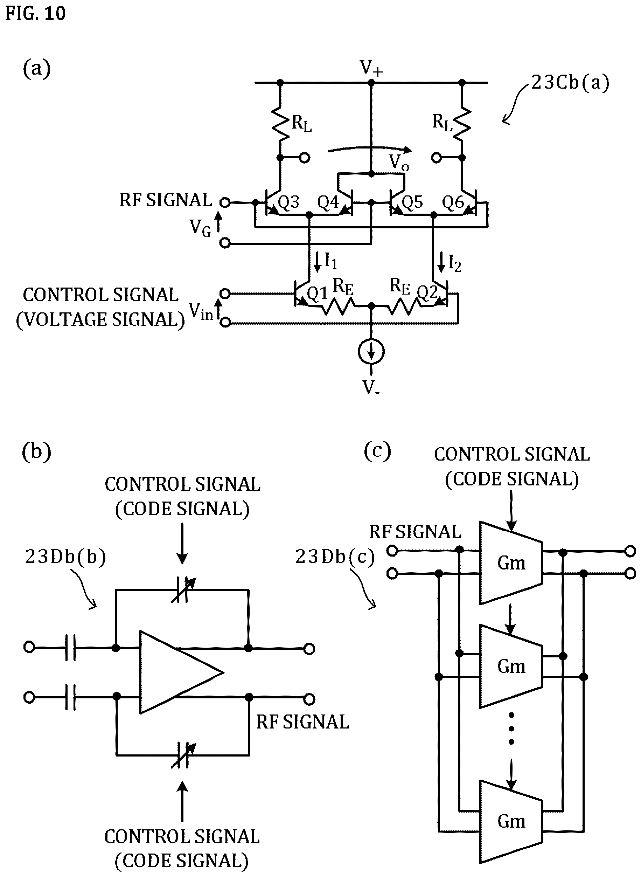

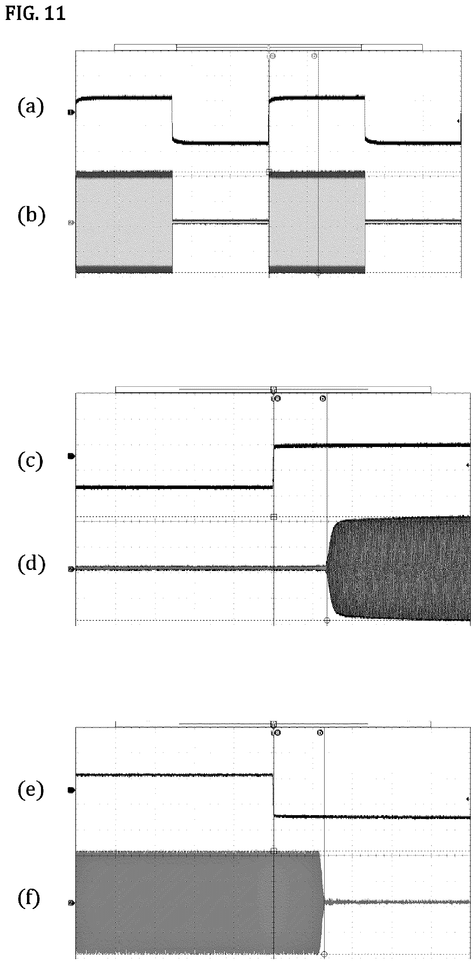

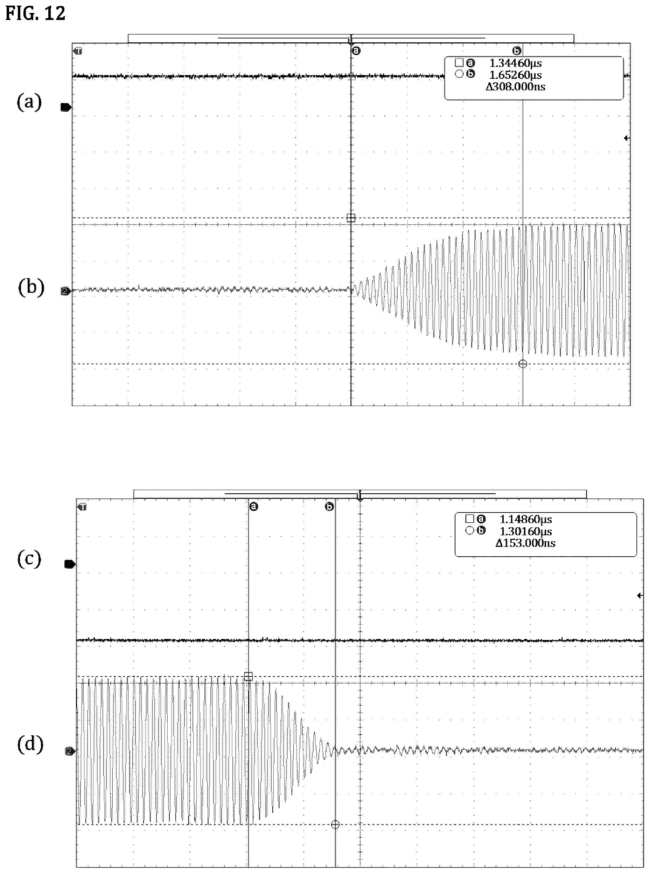

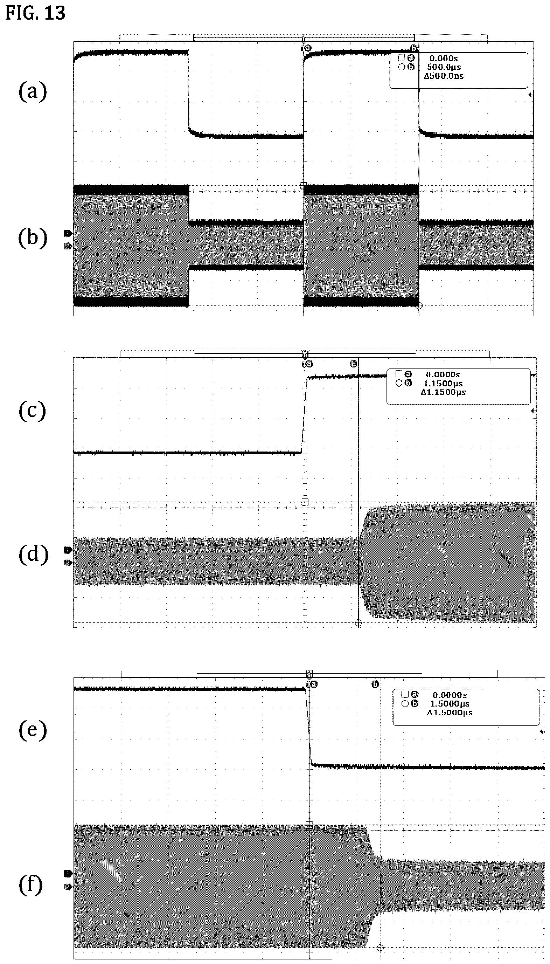

Figure 1 illustrates a schematic configuration of a high-frequency power supply of the present invention, FIG. 2 shows an example of an RF pulse signal, FIG. 3 shows examples schematically showing a control signal and the RF pulse signal, and FIG. 4 shows an example of the control signal. In addition, FIG. 5 shows a first configuration example of the high-frequency power supply, and FIG. 6 shows a configuration example of a variable attenuator amplifier. FIG. 7 shows a second configuration example of the high-frequency power supply, FIG. 8 shows a third configuration example of the high-frequency power supply, and FIG. 9 shows a fourth configuration example of the high-frequency power supply. FIG. 10 shows a configuration example of a conductance amplifier. FIG. 11 shows examples of the control signal and an ON/OFF pulse signal, FIG. 12 shows an enlarged view of the example of the ON/OFF pulse signal, and FIG. 13 shows examples of the control signal and a multi-pulse signal.

### <Schematic Configuration of High-Frequency Power Supply of Present Invention>

A schematic configuration of a high-frequency power supply of the invention will now be described by referring to FIG. 1.

A high-frequency power supply 10 includes an RF pulse signal generation unit 20 that converts an RF signal into pulses to generate an RF pulse signal, and a control unit 30 that outputs setting data for controlling the RF pulse signal generation unit 20. The RF pulse signal generated in the RF pulse signal generation unit 20 is subjected to power amplification in a power amplification unit 40 and is then output from an output end.

Between the power amplification unit 40 and the output end of the high-frequency power supply 10, an output power detection unit 50 is provided. The power amplification unit 40 amplifies the power of an RF pulse signal 28, so as to supply power required of a load. The output power detection unit 50 detects the power of the RF pulse signal 28 amplified in the power amplification unit 40. The output power detection unit 50 divides output power into traveling-wave power and reflected-wave power by using a directional detector, not shown, converts the divided traveling-wave power and reflected-wave power into a traveling-wave detected signal and a reflected-wave detected signal by a detector, not shown, and feeds the converted signals back to the control unit 30.

The control unit 30 performs feedback control based on a set value of the output power as well as the traveling-wave detected signal and the reflected-wave detected signal thus fed back, so as to generate setting data such that the output power becomes the set value. The set value of the output power may be stored in the control unit 30 to read out sequentially for setting, or it may be set by inputting from an input device, not shown.

The setting data includes frequency setting data 24 and control setting data 25. The frequency setting data 24 sets the frequency of the RF signal contained in the RF pulse signal 28 thus obtained. The control setting data 25 sets a cycle and a duty ratio of the RF pulse signal 28 as well as an output level of the RF pulse signal. The cycle and the duty ratio of the RF pulse signal 28 define an amount of output power, and the output level of the RF pulse signal 28 defines a peak value of a voltage.

The RF pulse signal generation unit 20 includes an RF signal generation unit 21, a pulse conversion/gain control signal generation unit 22, a pulse conversion/variable gain amplification unit 23 and a control line 29. The RF signal generation unit 21 inputs the frequency setting data 24 via the control unit 30 to thereby generate an RF signal at a frequency set in the frequency setting data 24.

The pulse conversion/gain control signal generation unit 22 generates a control signal 27 for controlling the pulse conversion/variable gain amplification unit 23. The control signal 27 performs pulse conversion control and level control on an RF signal 26 generated in the RF signal generation unit 21 to thereby generate the RF pulse signal 28.

The pulse conversion control is for deforming the waveform of the RF signal 26 such that it becomes a pulse waveform. The pulse waveform is generated based on the cycle and the duty ratio set in the control setting data 25.

The level control is for amplifying the level of the RF signal 26 in amplitude, and defining the level of the RF pulse signal 28 based on the output level set in the control setting data 25.

The pulse conversion/gain control signal generation unit 22 can be formed by using programmable devices, such as an application-specific interface circuit (ASIC), a field programmable gate array (FPGA), and a system-on-chip (SOC), in which the pulse conversion control for setting the cycle and the duty ratio and the level control for setting the output level based on the control setting data are programmed to perform the pulse conversion control and the level control based on the control setting data 25.

The pulse conversion/variable gain amplification unit 23 performs the pulse conversion control and the level control on the RF signal 26 based on the control signal 27 generated by the pulse conversion/gain control signal generation unit 22, so as to generate the RF pulse signal 28.

The control signal 27 can be in either of analog and digital signal forms. In the analog signal form, for example, a voltage signal of a bias voltage to be applied to a semiconductor element included in the pulse conversion/variable gain amplification unit 23 can be used as a control signal, and the pulse conversion control is performed based on the cycle and the duty ratio of the waveform of the voltage signal and the level control is performed based on the amplitude of the voltage signal.

In the digital signal form, a code signal for selecting an amount of attenuation and a conductance can be used as a control signal. The pulse conversion control is performed by specifying the cycle and duty ratio of a pulse signal by the code signal, and the level control is performed by changing an amplification gain by selectively switching a plurality of resistors, a capacitor or a conductance amplifier included in the pulse conversion/variable gain amplification unit 23 also by using the code signal.

The control signal 27 is transmitted to the pulse conversion/variable gain amplification unit 23 through a single control line 29 that is provided between the pulse conversion/gain control signal generation unit 22 and the pulse conversion/variable gain amplification unit 23.

Figure 2 shows an example of an RF pulse signal that is output from the high-frequency power supply 10 and has its power amplified, and the signal in this example has multi-pulse of high-pulse and low-pulse. The high-pulse and the low-pulse are formed by an RF signal with a frequency set in the frequency setting data, and the cycle and the duty ratio as well as the amplitude of each pulse are set in the control setting data.

Figure 3(a) shows an example of the control signal, and FIG. 3(b) shows an example of the control signal and the RF pulse signal. The example of the control signal shown in FIG. 3(a) is a signal that is set for generating an ON/OFF pulse that is composed of a signal portion S1 which defines an OFF state, a signal portion S2 which defines an ON state, a signal portion S3 which defines a rising state, and a signal portion S4 which defines a falling state. In here, the example shows that the control signal is an analog signal.

The signal portion S3 has a sloping waveform that rises from the signal portion S1 toward the signal portion S2, and the signal portion S4 has a sloping waveform that falls from the signal portion S2 toward the signal portion S1. The sloping waveform of the signal portion S3 has a time width ΔT1 that defines a time constant when the RF pulse signal rises, and the sloping waveform of the signal portion S4 has a time width ΔT2 that defines a time constant when the RF pulse signal falls. The time constants of the time widths ΔT1, ΔT2 are set to match a frequency response which varies depending on a stray capacitance in the pulse conversion/variable gain amplification unit 23 to thereby prevent the occurrence of jitter and overshoot/undershoot during the rise and the fall of the RF pulse signal.

In Figure 3(b), the RF pulse signal rises when a delay time ΔT3 elapses after the control signal rises and falls when a delay time ΔT4 elapses after the control signal falls. When the RF pulse signal rises and falls, the sloping waveforms of the control signal prevents the occurrence of the jitter and overshoot/undershoot. The control signal shown in FIG. 3 has a linear waveform as a sloping waveform, but is not limited to the linear waveform and may have a curved waveform in which the slope changes gradually.

Figure 4 shows examples of control signals. FIG. 4(a) shows an example of a control signal for generating an ON/OFF pulse, FIG. 4(b) shows an example of a control signal for generating a multi-pulse, and FIGS. 4(c) and 4(d) show examples of control signals of which cycles and duty ratios are different.

The ON/OFF pulse and the multi-pulse as well as the cycle and the duty ratio may be changed with the passage of time. Furthermore, the examples of the signals in FIGS. 2 to 4 are shown schematically for illustrative purposes and do not represent actual signals.

### <Configuration Example of High-Frequency Power Supply of the Present Invention>

A configuration example of the high-frequency power supply of the present invention will now be described. In the following, the configuration example shows that an aspect of a variable gain and an aspect of a control signal with the variable gain are combined in a pulse conversion/variable gain amplifier.

### (Aspect of variable gain)

In the aspect of the variable gain, the high-frequency power supply of the present invention has a form in which an amount of attenuation is varied to vary the gain and another form in which a mutual conductance of the conductance amplifier is varied to vary the gain. The form of varying the amount of attenuation includes a form in which resistance change in a semiconductor element which constitutes an attenuator and resistance change by switching a resistor vary the gain, and another form includes a form in which the change in the mutual conductance of the conductance amplifier varies the gain.

### (Aspect of control signal)

In the aspect of the control signal with the variable gain, the high-frequency power supply of the present invention has a form of an analog signal using a voltage signal and a form of a digital signal using a code signal.

First and second configuration examples vary the amount of attenuation to perform the pulse conversion and obtain the variable gain, and the first configuration example uses the voltage signal as a control signal and the second configuration example uses the code signal as a control signal. Third and fourth configuration examples vary the mutual conductance to perform the pulse conversion and obtain the variable gain, and the third configuration example uses the voltage signal as a control signal and the fourth configuration example uses the code signal as a control signal.

### (First Configuration Example)

Figure 5 shows the first configuration example. A high-frequency power supply 10A in the first configuration example includes, as with the high-frequency power supply 10 shown in FIG. 1, an RF pulse signal generation unit 20A, a control unit 30A, a power amplification unit 40A and an output power detection unit 50A, and is configured to use an analog voltage signal as a control signal and vary an amount of attenuation by resistance change in a semiconductor element, so as to perform pulse conversion and obtain a variable gain.

The RF pulse signal generation unit 20A includes an RF signal generation unit 21A, a pulse conversion/gain control signal generation unit 22A and a variable attenuator amplifier 23A. The variable attenuator amplifier 23A is a component corresponding to the variable gain amplification unit 23.

The pulse conversion/gain control signal generation unit 22A includes a programmable control unit 22Aa, an analog/digital conversion unit (D/A) 22Ab and an operational amplifier (OPAMP) 22Ac. The programmable control unit 22Aa is a control unit configured to program pulse conversion control for setting a cycle and a duty ratio based on control setting data and level control for setting an output level based on the control setting data to thereby perform the pulse conversion and gain control according to the programs, and can be formed by using programmable devices, such as an application-specific interface circuit (ASIC), a field programmable gate array (FPGA), and a system-on-chip (SOC).

The variable attenuator amplifier 23A includes a gain control interface 23Aa, an amplifier 23Ab, and a variable attenuator 23Ac connected on an input end side of the amplifier 23Ab. The gain control interface 23Aa generates a voltage signal for controlling an amount of attenuation of the variable attenuator 23Ac based on an input control signal. The amount of attenuation of the variable attenuator 23Ac can be varied by the voltage signal. Since the amount of attenuation of the variable attenuator 23Ac is variable, the pulse conversion and level control are performed on an RF signal generated in the RF signal generation unit 21A to thereby output an RF pulse signal. The output from the variable attenuator 23Ac is subjected to signal amplification by the amplifier 23Ab, and then output as the RF pulse signal 28 to the power amplification unit 40A.

The analog/digital conversion unit (D/A) 22Ab changes the code signal generated by the programmable control unit 22Aa into analog form and converts it into a voltage signal. The variable attenuator 23Ac uses the voltage signal from the analog/digital conversion unit (D/A) 22Ab as a control signal to change the resistance of a semiconductor element, which is not shown in FIG. 5, thereby varying the amount of attenuation of the RF signal 26. FIG. 5 illustrates that an attenuator network consisting of resistive element is employed as the variable attenuator 23Ac.

Figure 6 briefly shows a configuration example of the variable attenuator 23Ac. FIG. 6(a) shows a variable attenuator 23Ac(a) that is an example of a configuration of an attenuator network formed by a T-type bridge circuit using a PIN diode as a semiconductor element. The variable attenuator 23Ac(a) changes a current flowing through the PIN diode by using the voltage signal as a control signal to vary the amount of attenuation, so as to increase or decrease an amount of current that flows in a load. The attenuator network is not limited to the T-type circuit and can be formed by a π-type circuit.

Figure 6(b) show a variable attenuator 23Ac(b) that is an example of a configuration of the attenuator network formed by using FET as a semiconductor element along with an operational amplifier. In this figure, the resistance of the FET changes when the voltage signal as the control signal is input to a gate. A gain of the operational amplifier can be varied due to the change in the resistance of FET. By varying the gain of the operational amplifier, the pulse conversion and the level control are performed on the RF signal generated by the RF signal generation unit 21A to thereby output the RF pulse signal. The circuit configurations shown in FIGS. 6(a) and 6(b) are simplified representations of known variable attenuator configurations.

### (Second Configuration Example)

Figure 7 shows a second configuration example. A high-frequency power supply 10B in the second configuration example includes, as with the high-frequency power supply 10 shown in FIG. 1, an RF pulse signal generation unit 20B, a control unit 30B, a power amplification unit 40B and an output power detection unit 50B, and is configured to use a code signal to vary a resistance value to thereby perform pulse conversion and obtain a variable gain.

The RF pulse signal generation unit 20B includes an RF signal generation unit 21B, a pulse conversion/gain control signal generation unit 22B and a variable attenuator amplifier 23B. The variable attenuator amplifier 23B is a component corresponding to the pulse conversion/variable gain amplification unit 23.

The pulse conversion/gain control signal generation unit 22B includes a programmable control unit 22Ba. The programmable control unit 22Ba is a control unit configured to program pulse conversion control for setting a cycle and a duty ratio based on control setting data 25 and level control for setting an output level based on the control setting data 25 to thereby perform the control according to the programs, and can be formed by using programmable devices, such as an application-specific interface circuit (ASIC), a field programmable gate array (FPGA), and a system-on-chip (SOC). The programmable control unit 22Ba outputs a control signal 27 in the form of a code signal.

The variable attenuator amplifier 23B includes a gain control interface 23Ba, an operational amplifier 23Bb, and a feedback resister 23Bc that is composed of a plurality of resisters connected between an output end side and an input end side of the operational amplifier 23Bb.

In the feedback resister 23Bc, the plurality of resisters, which are connected in parallel to one another, can be switched by a switching signal. The gain control interface 23Ba generates a selection signal for selecting any one of resisters of the feedback resister 23Bc based on the code signal of the input control signal 27. A gain of the operational amplifier 23Bb can be varied by the selected resister of the feedback resister 23Bc. The operational amplifier 23Bb performs the pulse conversion and the level control on the RF signal 26 generated by the RF signal generation unit 21B to thereby output the RF pulse signal 28.

### (Third Configuration Example)

Figure 8 shows a third configuration example. A high-frequency power supply 10C in the third configuration example includes, as with the high-frequency power supply 10 shown in FIG. 1, an RF pulse signal generation unit 20C, a control unit 30C, a power amplification unit 40C and an output power detection unit 50C, and is configured to use an analog control signal to change a mutual conductance to thereby perform pulse conversion and obtain a variable gain.

The RF pulse signal generation unit 20C includes an RF signal generation unit 21C, a pulse conversion/gain control signal generation unit 22C and a conductance amplifier 23C. The conductance amplifier 23C is a component corresponding to the pulse conversion/variable gain control amplification unit 23.

The pulse conversion/gain control signal generation unit 22C includes a programmable control unit 22Ca, an analog/digital conversion unit (D/A) 22Cb and an operational amplifier 22Cc (OPAMP). The programmable control unit 22Ca is a control unit configured to program pulse conversion control for setting a cycle and a duty ratio based on control setting data and level control for setting an output level based on the control setting data, and can be formed by using programmable devices, such as an application-specific interface circuit (ASIC), a field programmable gate array (FPGA), and a system-on-chip (SOC).

The analog/digital conversion unit (D/A) 22Cb changes a code signal generated by the programmable control unit 22Ca into analog form and converts into a voltage signal. The operational amplifier 22Cc (OPAMP) amplifies the voltage signal obtained from the analog/digital conversion unit (D/A) 22Cb to thereby output it as a control signal 27.

The conductance amplifier 23C includes a gain control interface 23Ca and a conductance amplification circuit 23Cb. The gain control interface 23Ca generates a voltage signal for controlling a gain of the conductance amplification circuit 23Cb based on the input control signal 27. A mutual conductance of the conductance amplification circuit 23Cb is changed by the voltage signal. The mutual conductance varies the gain of the conductance amplification circuit 23Cb. The conductance amplification circuit 23Cb performs the pulse conversion and the level control on an RF signal 26 generated by the RF signal generation unit 21C to output an RF pulse signal 28.

Figure 10(a) shows a configuration example of the conductance amplification circuit 23Cb. A conductance amplification circuit 23Cb(a) consists of a mutual conductance (Gm) stage consisting of transistors Q1 and Q2, emitter resistances R_{E}, a current source, and a current steering stage consisting of transistors Q3 to Q6 to which resistance loads R_{L} are connected. An input signal Vin generates output currents I1 and I2 through the Gm step. A gain control voltage V_{G} is set so that the current applied to load resistances R are changed, thereby obtaining an output voltage Vₒ.

### (Fourth Configuration Example)

Figure 9 shows a fourth configuration example. A high-frequency power supply 10D in the fourth configuration example includes, as with the high-frequency power supply 10 shown in FIG. 1, an RF pulse signal generation unit 20D, a control unit 30D, a power amplification unit 40D and an output power detection unit 50D, and is configured to use a code signal to change a mutual conductance to thereby perform pulse conversion and obtain a variable gain.

The RF pulse signal generation unit 20D includes an RF signal generation unit 21D, a pulse conversion/gain control signal generation unit 22D and a conductance amplifier 23D. The conductance amplifier 23D is a component corresponding to the pulse conversion/variable gain amplification unit 23.

The pulse conversion/gain control signal generation unit 22D includes a programmable control unit 22Da. The programmable control unit 22Da is a control unit configured to program pulse conversion control for setting a cycle and a duty ratio based on control setting data 25 and level control for setting an output level based on the control setting data 25 to thereby perform the control according to the programs, and can be formed by using programmable devices, such as an application-specific interface circuit (ASIC), a field programmable gate array (FPGA), and a system-on-chip (SOC). The programmable control unit 22Da outputs a control signal 27 in the form of a code signal.

The conductance amplifier 23D includes a gain control interface 23Da and a conductance amplification circuit 23Db. The gain control interface 23Da generates a switching signal for controlling a gain of the conductance amplification circuit 23Db based on the input control signal 27. The switching signal changes a mutual conductance of the conductance amplification circuit 23Db. The gain of the conductance amplification circuit 23Db becomes variable due to the change in the mutual conductance. The conductance amplification circuit 23Db performs the pulse conversion as well as the level control on an RF signal 26 generated in the RF signal generation unit 21D to output an RF pulse signal 28.

Figures 10(b) and 10(c) show configuration examples of the conductance amplification circuit 23Db. A conductance amplification circuit 23Db(b) shown in FIG. 10(b) is configured to connect capacitors having different capacitance between input ends and output ends of operational amplifiers and select the capacitor by a switching signal. By selecting a conductance amplification circuit (Gm) or the capacitor by the switching signal, the mutual conductance of the conductance amplification circuit 23Db is changed to perform the pulse conversion and obtain a variable gain.

A conductance amplification circuit 23Db(c) shown in FIG. 10(c) is formed by connecting a plurality of conductance amplification circuits (Gm) having different mutual conductance in parallel, and is configured to select the conductance amplification circuit (Gm) to be used by the switching signal.

### (Signal Example)

Some signal examples according to the high-frequency power supply of the present invention will now be described by referring to FIGS. 11 to 13. FIGS. 11 and 12 show cases where an output RF pulse signal has an ON/OFF pulse.

Figures 11(a), 11(c) and 11(e) show a control signal output by the pulse conversion/gain control signal generation unit, and FIGS. 11(b), 11(d) and 11(f) show examples of an RF pulse signal output from the variable gain amplifier. These figures show examples that the control signal is a voltage signal.

Figures 11(c) and 11(d) show the states of the signals when they rise, with enlarged time axes. Furthermore, FIGS. 11(e) and 11(f) show the states of the signals when they fall, with enlarged time axes.

Figures 12(a) and 12(b) show examples of the states of a control signal output by the pulse conversion/gain control signal generation unit and an RF pulse signal output from the variable gain amplifier when they rise, with enlarged time axes. In addition, FIGS. 12(c) and 12(d) show the states of the control signal output by the pulse conversion/gain control signal generation unit and the RF pulse signal output from the variable gain amplifier when they fall, with enlarged time axes. In the signal examples shown, there are no jitter and overshoot/undershoot.

Figure 13 shows an example of an output RF pulse signal having a multi-pulse.

Figures 13(a), 13(c) and 13(e) show a control signal output by the pulse conversion/gain control signal generation unit, and FIGS. 13(b), 13(d) and 13(f) show examples of an RF pulse signal output from the variable gain amplifier. These figures show examples that the control signal is a voltage signal.

Figures 13(c) and 13(d) show examples of the states of the signals when they rise, with enlarged time axes, and FIGS. 13(e) and 13(f) show the states of the signals when they fall, with enlarged time axes. In the signal examples shown, there are no jitter and overshoot/undershoot even in the case of the multi-pulse, as with the case of the ON/OFF pulse.

The above-described embodiments and variations are some examples of the high-frequency power supply of the present invention, and the present invention is not limited to these embodiments. The present invention can be varied based on the gist of the invention, and such variations will not be excluded from the scope of the invention.

### [INDUSTRIAL APPLICABILITY]

The high-frequency power supply of the present invention can be applied to a high-frequency power supply (RF generator) which is used for semiconductor manufacturing equipment, liquid crystal panel manufacturing equipment and others.

### [REFERENCE SIGNS LIST]

10, 10A, 10B, 10C, 10D High-Frequency Power Supply
20 RF Pulse Signal Generation Unit
20A, 20B, 20C, 20D RF Pulse Signal Generation Unit
21, 21A, 21B, 21C, 21D RF Signal Generation Unit
22, 22A, 22B, 22C, 22D Pulse Conversion/Gain Control Signal Generation Unit
22Aa, 22Ba, 22Ca, 22Da Programmable Control Unit
22Ab, 22Cb Analog/Digital Conversion Unit (D/A)
22Ac, 22Cc Operational Amplifier
23 Pulse Conversion/Variable Gain Amplification Unit
23A, 23B Variable Attenuator Amplifier
23Aa, 23Ba, 23Ca, 23Da Gain Control Interface
23Ab Amplifier
23Ac Variable Attenuator
23Bb Operational Amplifier
23Bc Feedback Resister
23C, 23D Conductance Amplifier
23Cb, 23Db Conductance Amplification Circuit
24 Frequency Setting Data
25 Control Setting Data
26 RF Signal
27 Control Signal
28 RF Pulse Signal
29 Control Line
30, 30A, 30B, 30C, 30D Control Unit
40, 40A, 40B, 40C, 40D Power Amplification Unit
50, 50A, 50B, 50C, 50D Output Power Detection Unit
100 High-Frequency Power Supply
120 RF Pulse Signal Generation Unit
120a Oscillation Unit
120b Modulation Unit
120c Level Adjustment Unit
120c1 Level Modulation Circuit
120c2 D/A Circuit
130 Control Unit
140 Power Amplification Unit
150 Output Power Detection Unit
160 Load

## Claims

1. A high-frequency power supply, comprising:
an RF pulse signal generation unit that converts an RF signal into pulses to generate an RF pulse signal; and
a control unit that outputs setting data for controlling the RF pulse signal generation unit,
wherein the setting data is frequency setting data for setting a frequency of the RF signal and control setting data for setting a cycle and a duty ratio of the RF pulse signal as well as an output level of the RF pulse signal,
the RF pulse signal generation unit comprises:
an RF signal generation unit that generates, based on the frequency setting data, an RF signal at a frequency set in the frequency setting data;
a pulse conversion/gain control signal generation unit that generates, based on the control setting data, a control signal for performing pulse conversion control on the RF signal in the cycle and at the duty ratio set in the control setting data and level control on the RF signal at the output level set in the control setting data;
a pulse conversion/variable gain amplification unit that generates the RF pulse signal from the RF signal based on the control signal; and
a single control line that connects the pulse conversion/gain control signal generation unit to the pulse conversion/variable gain amplification unit to transmit the control signal,
the pulse conversion/variable gain amplification unit performs, based on the control signal, the pulse conversion control for converting the RF signal into pulses in the set cycle and at the set duty ratio, variable control on an amplification gain of the RF signal, and the level control on the level of the RF signal to be the set output level.

2. The high-frequency power supply according to claim 1, wherein the control signal has sloping waveforms on its rising and falling edges, and
the pulse conversion/variable gain amplification unit generates an RF pulse signal having a rise time and a fall time during rising and falling.

3. The high-frequency power supply according to claim 1 or 2, wherein the pulse conversion/variable gain amplification unit is a variable attenuator amplifier that varies an amount of attenuation of the RF signal by using the control signal, in which
the control signal is a voltage signal,
the variable attenuator amplifier comprises a variable attenuator, and changes an amount of attenuation of an RF signal passing through the variable attenuator by using the voltage signal to thereby perform the variable control on the amplification gain and the level control on the RF pulse signal.

4. The high-frequency power supply according to claim 3, wherein the variable attenuator comprises a semiconductor element, and changes the amount of attenuation of the RF signal due to change in a resistance component of the semiconductor element by using the voltage signal to thereby perform the variable control on the amplification gain and the level control on the RF pulse signal.

5. The high-frequency power supply according to claim 4, wherein the variable attenuator forms an attenuator network with the semiconductor element and resistive elements.

6. The high-frequency power supply according to claim 1 or 2, wherein the pulse conversion/variable gain amplification unit is a variable attenuator amplifier for varying the amount of attenuation of the RF signal by using the control signal, in which
the control signal is a control code,
the variable attenuator amplifier comprises a variable attenuator consisting of a plurality of resisters having different resistance values, and switches the resisters by using the control code to perform the variable control on the amplification gain and the level control on the RF pulse signal.

7. The high-frequency power supply according to claim 1 or 2, wherein the pulse conversion/variable gain amplification unit is a conductance amplifier that varies a mutual conductance by using the control signal, in which
the control signal is a voltage signal, and
the conductance amplifier comprises a semiconductor element, and performs the variable control on the amplification gain by changing the mutual conductance of the semiconductor element by using the voltage signal and the level control on the RF pulse signal.

8. The high-frequency power supply according to claim 1 or 2, wherein the pulse conversion/variable gain amplification unit is a conductance amplifier that varies a mutual conductance by using the control signal, in which
the control signal is a control code, and
the conductance amplifier performs the variable control on the amplification gain by changing the mutual conductance by using the control code and the level control on the RF pulse signal.

9. The high-frequency power supply according to claim 8, wherein the conductance amplifier comprises a plurality of capacitors having different capacitance values,
the pulse conversion/variable gain amplification unit switches the capacitors by using the control code to vary the mutual conductance, thereby performing the variable control on the amplification gain and the level control on the RF pulse signal.

10. The high-frequency power supply according to claim 8, wherein the pulse conversion/variable gain amplification unit comprises a plurality of conductance amplifiers having different mutual conductance values, and switches the conductance amplifiers by using the control code to vary the mutual conductance, thereby performing the variable control on the amplification gain and the level control on the RF pulse signal.
